# FASCICULE DE BREVET EUROPEEN

(11) **EP 4 332 728 B1**
(45) Date de publication et mention de la délivrance du brevet: **09.07.2025**
(21) Numéro de dépôt: 22306290.2
(22) Date de dépôt: 31.08.2022
(51) Int. Cl.: G06F 1/20, G06F 1/18, H05K 7/20

(54) **LAME DE CALCUL À CARTES RÉSEAU DÉPORTÉES**
COMPUTERBLADE MIT VERSETZTEN NETZWERKKARTEN
COMPUTING BLADE WITH OFFSET NETWORK CARDS

(43) Date de publication de la demande: 06.03.2024
(73) Titulaire: BULL SAS, 78340 Les Clayes-Sous-Bois (FR); Commissariat à l'Energie Atomique et aux Energies Alternatives, 75015 Paris (FR)
(72) Inventeur: MAGNOUX, Sébastien, 95540 MERY-SUR-OISE (FR)
(74) Mandataire: Argyma

(56) Documents cités:
- EP-A1- 3 500 079
- US-A1- 2022 229 798

## Description

### [Domaine technique]

La présente invention se rapporte au domaine des supercalculateurs et concerne plus particulièrement une lame de calcul à refroidissement liquide pour supercalculateur ainsi qu'un supercalculateur comprenant au moins une telle lame de calcul.

### [Etat de la technique antérieure]

Un calculateur HPC (High Performance Computing), ou supercalculateur, comprend une pluralité de lames de calcul se présentant sous la forme de modules insérés dans une baie. Chaque lame de calcul comprend une carte mère comportant une pluralité de processeurs configurés chacun pour traiter des données. Chaque lame de calcul comporte également des cartes réseau haute vitesse, par exemple de type mezzanine Ethernet^{®} (carte OCP3), afin de permettre la communication entre les lames de calcul et l'utilisation de la puissance de plusieurs processeurs pour l'exécution d'une même tâche. Pour être fonctionnelle, chacune de ces cartes réseau doit être connectée à la carte mère.

Dans les calculateurs HPC à refroidissement à air, le système classique de connexion se fait de carte à carte, c'est-à-dire que la carte réseau est guidée dans un châssis mécanique jusqu'au connecteur de la carte mère et l'insertion se fait manuellement ou à l'aide d'un levier d'insertion.

Dans les calculateurs HPC à refroidissement liquide, la carte mère est montée d'un côté de la plaque froide, à travers laquelle sont montés des dissipateurs thermiques permettant de refroidir les processeurs. Or, une telle configuration peut rendre l'insertion et la connexion carte à carte des cartes réseau avec la carte mère particulièrement complexe, notamment du fait du manque d'espace autour de la carte mère. En outre, chaque carte réseau doit avoir une interface thermique avec la plaque froide dans laquelle circule le liquide de refroidissement afin de refroidir ladite carte réseau. La connexion carte à carte classique n'est donc pas satisfaisante pour ce type de lame de calcul.

Le document EP3500079A1 concerne un système de refroidissement liquide d'une carte électronique pouvant être inefficace ou inadapté. Le document US2022229798A1 décrit un système de traitement d'informations avec une carte à palette flottante pouvant être inefficace ou inadapté.

Il existe donc le besoin d'une solution simple et efficace permettant de remédier au moins en partie à ces inconvénients.

### [Exposé de l'invention]

A cette fin, l'invention a tout d'abord pour objet une lame de calcul pour supercalculateur multi-lames de calcul, ladite lame de calcul comprenant une carte mère, comportant une pluralité de processeurs montés sur un support, et une plaque froide, dimensionnée pour recouvrir le support des processeurs et comprenant une pluralité de dissipateurs thermiques, un circuit de refroidissement comportant des canaux à l'intérieur desquels circule un fluide caloporteur dit « froid », destiné à alimenter les dissipateurs thermiques, et un circuit d'évacuation comportant des canaux à l'intérieur desquels circule un fluide caloporteur dit « chaud » s'étant réchauffé à travers les dissipateurs thermiques, chaque dissipateur thermique étant monté au droit d'un processeur afin de le refroidir par échange de chaleur, la lame de calcul comprenant autant de cartes réseau que de processeurs, chaque carte réseau étant associée à un processeur, chaque carte réseau comprenant une extrémité d'enfichage configurée pour recevoir un connecteur, chaque carte réseau étant configurée pour permettre la communication de données entre ledit processeur et un autre processeur de la lame de calcul ou d'une autre lame de calcul, la lame de calcul étant remarquable en ce que chaque carte réseau est montée sur la plaque froide en étant connectée à la carte mère via un système de connexion, ledit système comprenant un premier connecteur, connecté à l'extrémité d'enfichage de la carte réseau, et un deuxième connecteur, relié d'une part au premier connecteur via un câble et d'autre part à la carte mère.

La lame de calcul à refroidissement liquide selon l'invention permet la connexion électrique des cartes réseau à la carte mère via les systèmes de connexion. Le système de connexion d'une carte réseau permet ainsi de connecter ladite carte réseau à la carte mère à distance via un câble de sorte que les cartes réseau peuvent être déportées par rapport à la carte mère tout en assurant leur refroidissement par la plaque froide. Les cartes réseau peuvent ainsi être disposées sur le côté opposé de la plaque froide par rapport à la carte mère, à un endroit disposant de suffisamment de place. La lame de calcul selon l'invention permet donc d'optimiser l'espace disponible des deux côtés de la plaque froide, notamment en rendant le placement des cartes réseau indépendant du placement de la carte mère grâce au système de connexion à distance entre la carte mère et les cartes réseau. Le système de connexion à câble et connecteurs permet aussi de connecter et déconnecter facilement les cartes réseau de la carte mère. Le déport des cartes réseau par rapport à la carte mère peut aussi permettre de changer facilement une carte réseau en cas de maintenance lorsque les cartes réseau sont montées à un endroit facilement accessible de la lame de calcul.

De préférence, le câble du système de connexion est flexible pour faciliter le positionnement et le branchement du premier connecteur et du deuxième connecteur.

De préférence encore, le deuxième connecteur est relié à la carte mère à travers la plaque froide afin d'accéder à la carte mère par le chemin le plus court et optimiser ainsi l'espace occupé par la lame et ses composants. En variante ou en complément, tout ou partie des deuxièmes connecteurs pourraient être reliés à la carte mère par des câbles contournant la plaque froide par un ou plusieurs de ses bords.

Avantageusement, chaque carte réseau est montée sur la plaque froide par l'intermédiaire d'une pièce de support, notamment de sorte à permettre l'utilisation de cartes réseau standards vendues dans le commerce.

Dans une forme de réalisation, la pièce de support comprend un corps et un dispositif de maintien du premier connecteur, monté sur ledit corps, afin de maintenir le connecteur en position connectée de façon optimisée et éviter ainsi qu'il ne bouge lors du transport ou lors de l'utilisation de la lame de calcul.

De préférence, le dispositif de maintien comprend une lame de support du premier connecteur et une plaque de maintien du premier connecteur sur ladite lame de support.

Avantageusement, la lame de support est réalisée en métal, de préférence en aluminium, afin de résister à des températures élevées auxquelles les composants internes à la lame de calcul peuvent être soumis tout en étant peu onéreux.

Avantageusement encore, la plaque de maintien est réalisée en métal, de préférence en acier, afin de résister à des températures élevées auxquelles les composants internes à la lame de calcul peuvent être soumis tout en étant peu onéreux.

Dans une forme de réalisation de l'invention, la plaque de maintien est fixée sur la lame de support à l'aide d'au moins une vis, de préférence à l'aide de deux vis, afin de bloquer efficacement le premier connecteur en position connectée dans le dispositif de maintien.

De manière préférée, l'au moins une vis est captive ou imperdable.

Dans une forme de réalisation, l'au moins une vis captive ou imperdable est montée au niveau de la plaque de maintien, de sorte à éviter qu'elle ne s'échappe lors du transport ou de la fixation ou du retrait du premier connecteur.

De préférence, la lame de support est fixée au corps de la pièce de support en étant déportée d'une distance par rapport à la plaque froide afin d'adapter la position du premier connecteur à l'extrémité d'enfichage de la carte réseau.

Avantageusement, le corps de la pièce de support est réalisé en un matériau conducteur d'énergie thermique, de préférence en aluminium, afin de permettre un refroidissement efficace de la carte réseau.

Dans une forme de réalisation, chaque carte réseau est fixée sur un bord de la lame de calcul, de préférence un même bord, par une extrémité de fixation, opposée à l'extrémité d'enfichage. Les cartes réseau peuvent alors être connectées aisément à un réseau de communication via des câbles de type Ethernet^{®}.

Un mode de réalisation concerne également un serveur, notamment un supercalculateur, comprenant au moins une lame de calcul telle que présentée ci-avant.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig 1] La figure 1 illustre schématiquement et en transparence une forme de réalisation du supercalculateur selon un mode de réalisation de l'invention.
[Fig 2] La figure 2 illustre schématiquement une lame de calcul du supercalculateur de la figure 1.
[Fig 3] La figure 3 illustre schématiquement une carte réseau montée sur une pièce de support de la lame de la figure 2.
[Fig 4] La figure 4 illustre schématiquement la pièce de support et la carte réseau de la figure 2, à laquelle est connectée le premier connecteur en vue partielle.

### [Description des modes de réalisation]

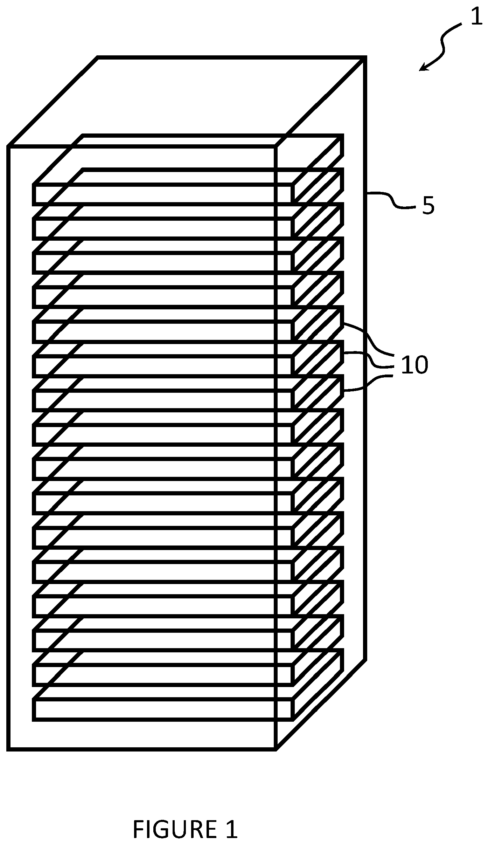

La figure 1 illustre un exemple de supercalculateur 1 selon un mode de réalisation de l'invention.

### Supercalculateur 1

Le supercalculateur 1 comprend une baie 5 dans laquelle sont montées une pluralité de lames de calcul 10 selon l'invention. Dans cet exemple non limitatif, les lames de calcul 10 sont montées en étant superposées verticalement, par exemple sur des rails de guidage.

Plus généralement, le supercalculateur 1 pourrait être un serveur ou tout type de baie informatique dans laquelle il est nécessaire de monter au moins un module de calcul multiprocesseur à refroidissement liquide.

### Lame de calcul 10

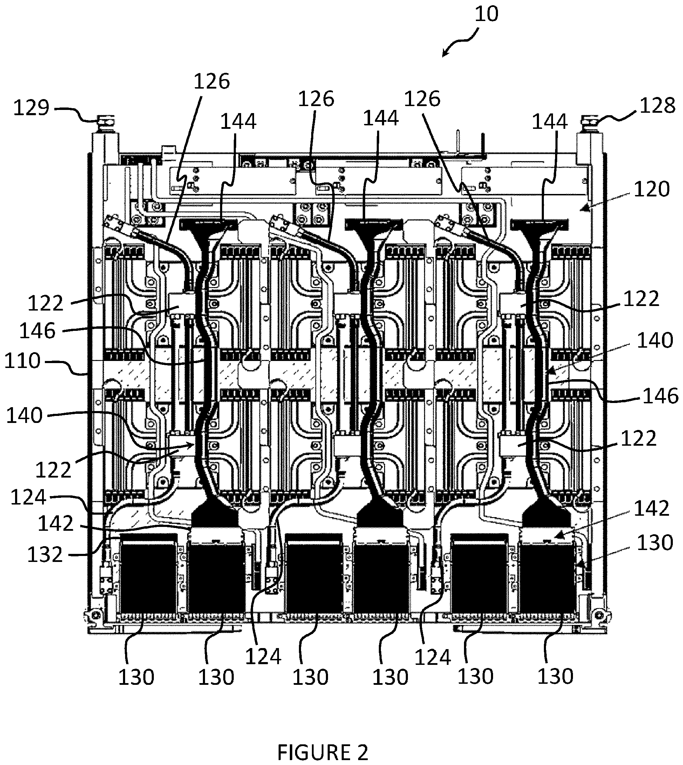

La figure 2 illustre un exemple de lame de calcul 10 selon l'invention.

La lame de calcul 10 comprend tout d'abord une carte mère 110 et une plaque froide 120.

### Carte mère 110

La carte mère 110 comprend une pluralité de processeurs (non visibles car sous la plaque froide 120) montés sur un support (également non visible car sous la plaque froide 120).

### Plaque froide 120

La plaque froide 120 est dimensionnée pour recouvrir le support des processeurs et comprend une pluralité de dissipateurs thermiques 122, un circuit de refroidissement 124, un circuit d'évacuation 126, un connecteur d'entrée dit « froid » 128 et un connecteur de sortie dit « chaud » 129.

Le circuit de refroidissement 124 comprend des canaux à l'intérieur desquels circule un fluide caloporteur dit « froid », entrant dans le circuit de refroidissement 124 par le connecteur d'entrée froid 128 et qui est destiné à alimenter les dissipateurs thermiques 122.

Chaque dissipateur thermique 122 est monté au droit d'un processeur afin de le refroidir par échange de chaleur.

Le circuit d'évacuation 126 comprend des canaux à l'intérieur desquels circule un fluide caloporteur dit « chaud » s'étant réchauffé à travers les dissipateurs thermiques 122 et qui est évacué par le connecteur de sortie chaud 129.

La lame de calcul 10 comprend ensuite une pluralité de cartes réseau 130. Plus précisément, la lame de calcul 10 comprend autant de cartes réseau 130 que de processeurs, chaque carte réseau 130 étant associée à un processeur.

Chaque carte réseau 130 comprend une extrémité d'enfichage 132 configurée pour recevoir un connecteur et est configurée pour permettre la communication de données entre le processeur auquel ladite carte réseau 130 est associée et un autre processeur de la lame de calcul 10 ou d'une autre lame de calcul 10 (du supercalculateur 1 ou d'un autre supercalculateur) via ladite extrémité d'enfichage 132.

Chaque carte réseau 130 est montée sur la plaque froide 120 en étant connectée à la carte mère 110 via un système de connexion 140.

Le système de connexion 140 comprend un premier connecteur 142, un deuxième connecteur 144 et un câble (ou un faisceau de câbles) 146 reliant électriquement le premier connecteur 142 et le deuxième connecteur 144.

Le premier connecteur 142 est connecté sur l'extrémité d'enfichage 132 de la carte réseau 130. Le deuxième connecteur 144 est relié d'une part au premier connecteur 142 via le câble 146 et d'autre part à la carte mère 110.

Dans l'exemple de la figure 2, le deuxième connecteur 144 est relié à la carte mère 110 à travers la plaque froide 120 afin d'accéder à la carte mère 110 par un chemin court et optimiser ainsi l'espace occupé par la lame de calcul 10 et ses composants.

Le câble 146 est flexible de manière à pouvoir se conformer à l'espace formé entre les dissipateurs thermiques 122 et à la direction de connexion à la fois du premier connecteur 142 (ici parallèlement au plan selon lequel s'étend la plaque froide 120) et du deuxième connecteur 144 (ici orthogonalement au plan selon lequel s'étend la plaque froide 120).

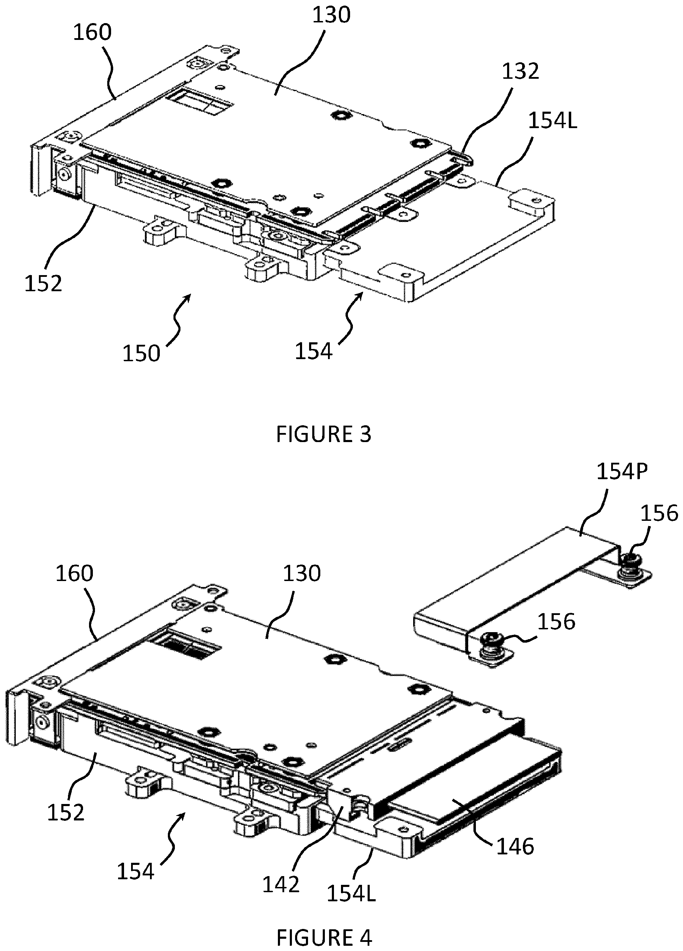

Chaque carte réseau 130 est montée sur la plaque froide 120 par l'intermédiaire d'une pièce de support 150, comme illustré sur la figure 3.

La pièce de support 150 comprend un corps 152 et un dispositif de maintien 154 monté sur ledit corps 152 et configuré pour maintenir le premier connecteur 142 lorsque ledit premier connecteur 142 est connecté sur l'extrémité d'enfichage 132 afin d'éviter que le premier connecteur 142 ne bouge lors du transport ou de l'utilisation de la lame de calcul 10. Autrement dit, le dispositif de maintien 154 permet de maintenir le connecteur en position connectée sur l'extrémité d'enfichage 132 de façon optimisée.

En référence à la figure 4, le dispositif de maintien 154 comprend une lame de support 154L et une plaque de maintien 154P. La lame de support 154L reçoit le premier connecteur 142 tandis que la plaque de maintien 154P bloque le premier connecteur 142 sur ladite lame de support 154L.

De préférence, la lame de support 154L est réalisée en métal, de préférence en aluminium pour conduire l'énergie thermique. De préférence encore, la plaque de maintien 154P est également réalisée en métal, de préférence en acier.

Toujours en référence à la figure 4, la plaque de maintien 154P est fixée sur la lame de support 154L à l'aide de deux vis 156 afin de bloquer le premier connecteur 142.

Chaque vis 156 est montée au niveau de la plaque de maintien 154P en étant captive ou imperdable, c'est-à-dire que ladite vis est libre en rotation pour se visser sur la lame de support 154L mais est retenue sur la plaque de maintien 154P de sorte à éviter qu'elle ne s'échappe lors du transport et de la fixation ou du retrait du premier connecteur 142.

La lame de support 154L est fixée au corps 152 de la pièce de support 150 et s'étend parallèlement à la plaque froide 120 en étant déportée d'une distance par rapport à ladite plaque froide 120.

Le corps 152 de la pièce de support 150 est réalisé en un matériau conducteur d'énergie thermique, par exemple en aluminium, afin de permettre le refroidissement de la carte réseau 130 par l'énergie thermique fournie par le fluide caloporteur circulant dans la plaque froide 120.

En référence à la figure 2, chaque carte réseau 130 est fixée sur un bord de la lame de calcul 10 par son extrémité de fixation, opposée à l'extrémité d'enfichage 132. En référence aux figures 3 et 4, un élément de fixation 160 métallique permet de fixer la carte réseau 130 sur le bord de la lame de calcul 10, par exemple par vissage ou blocage.

L'invention permet d'optimiser la répartition des composants de part et d'autre de la plaque froide 120, notamment de placer les cartes réseau 130 à l'endroit le plus adapté, en particulier sur la face opposée de la plaque froide 120 par rapport à la carte mère 110. L'invention permet donc d'obtenir une lame de calcul 10 peu encombrante et de maintenance aisée. En particulier, différents types et modèles de carte réseau peuvent être utilisées puisqu'elles ne sont plus contraintes par la position de la carte mère dans une configuration d'insertion carte à carte.

## Revendications

1. Lame de calcul (10) pour supercalculateur (1) multi-lames, ladite lame de calcul (10) comprenant une carte mère (110), comportant une pluralité de processeurs montés sur un support, et une plaque froide (120), dimensionnée pour recouvrir le support des processeurs et comprenant une pluralité de dissipateurs thermiques (122), un circuit de refroidissement (124) comportant des canaux à l'intérieur desquels circule un fluide caloporteur dit « froid », destiné à alimenter les dissipateurs thermiques (122), et un circuit d'évacuation (126) comportant des canaux à l'intérieur desquels circule un fluide caloporteur dit « chaud » s'étant réchauffé à travers les dissipateurs thermiques (122), chaque dissipateur thermique (122) étant monté au droit d'un processeur afin de le refroidir par échange de chaleur, la lame de calcul (10) comprenant autant de cartes réseau (130) que de processeurs, chaque carte réseau (130) étant associée à un processeur, chaque carte réseau (130) comprenant une extrémité d'enfichage (132) configurée pour recevoir un connecteur (142), chaque carte réseau (130) étant configurée pour permettre la communication de données entre ledit processeur et un autre processeur, la lame de calcul (10) étant **caractérisée en ce que** chaque carte réseau (130) est montée sur la plaque froide (120) en étant connectée à la carte mère (110) via un système de connexion (140), ledit système (140) comprenant un premier connecteur (142), connecté à l'extrémité d'enfichage (132) de la carte réseau (130), et un deuxième connecteur (144), relié d'une part au premier connecteur (142) via un câble (146) et d'autre part à la carte mère (110).

2. Lame de calcul (10) selon la revendication 1, dans laquelle le deuxième connecteur (144) est relié à la carte mère (110) à travers la plaque froide (120).

3. Lame de calcul (10) selon l'une quelconque des revendications précédentes, dans laquelle chaque carte réseau (130) est montée sur la plaque froide (120) par l'intermédiaire d'une pièce de support (150).

4. Lame de calcul (10) selon la revendication précédente, dans laquelle la pièce de support (150) comprend un corps (152) et un dispositif de maintien (154) du premier connecteur (142), monté sur ledit corps (152).

5. Lame de calcul (10) selon la revendication précédente, dans laquelle le dispositif de maintien (154) comprend une lame de support (154L) du premier connecteur (142) et une plaque de maintien (154P) du premier connecteur (142) sur ladite lame de support (154L).

6. Lame de calcul (10) selon la revendication précédente, dans laquelle la lame de support (154L) est réalisée en métal, de préférence en aluminium.

7. Lame de calcul (10) selon l'une quelconque des revendications 5 ou 6, dans laquelle la plaque de maintien (154P) est réalisée en métal, de préférence en acier.

8. Lame de calcul (10) selon l'une quelconque des revendications 5 à 7, dans laquelle la plaque de maintien (154P) est fixée sur la lame de support (154L) à l'aide d'au moins une vis (156), de préférence à l'aide de deux vis (156).

9. Lame de calcul (10) selon la revendication précédente, dans laquelle l'au moins une vis (156) est captive ou imperdable, et montée sur la plaque de maintien (154P).

10. Lame de calcul (10) selon l'une quelconque des revendications 5 à 9, dans laquelle la lame de support (154L) est fixée au corps (152) de la pièce de support (150) en étant déportée d'une distance par rapport à la plaque froide (120).

11. Lame de calcul (10) selon l'une quelconque des revendications 3 à 10, dans laquelle, le corps (152) de la pièce de support (150) est réalisé en un matériau conducteur d'énergie thermique.

12. Lame de calcul (10) selon la revendication précédente, dans laquelle le corps (152) de la pièce de support (150) est réalisé en aluminium.

13. Lame de calcul (10) selon l'une quelconque des revendications précédentes, dans laquelle le câble (146) du système de connexion (140) est flexible.

14. Lame de calcul (10) selon l'une quelconque des revendications précédentes, dans laquelle chaque carte réseau (130) est fixée sur un bord de la lame de calcul (10) par une extrémité de fixation, opposée à l'extrémité d'enfichage (132).

15. Supercalculateur (1) comprenant au moins une lame de calcul (10) selon l'une quelconque des revendications précédentes.

## Patentansprüche

1. Rechen-Blade (10) für einen Multi-Blade-Supercomputer (1), das Rechen-Blade (10) umfassend eine Hauptplatine (110), die eine Vielzahl von Prozessoren aufweist, die auf einem Träger montiert sind, und eine Kühlplatte (120), die zum Bedecken des Trägers der Prozessoren konfiguriert ist und umfassend eine Vielzahl von Kühlkörpern (122), einen Kühlkreislauf (124), der Kanäle aufweist, in denen ein sogenanntes "kaltes" Wärmeübertragungsfluid zirkuliert, das dazu bestimmt ist, die Kühlkörper (122) zu versorgen, und einen Ableitungskreislauf (126), der Kanäle aufweist, in denen ein sogenanntes "heißes" Wärmeübertragungsfluid zirkuliert, das sich durch die Kühlkörper (122) erwärmt hat, wobei jeder Kühlkörper (122) in Reihe mit einem Prozessor montiert ist, um ihn durch Wärmeaustausch zu kühlen, der Rechen-Blade (10) umfassend so viele Netzwerkkarten (130) wie Prozessoren, wobei jede Netzwerkkarte (130) einem Prozessor zugeordnet ist, jede Netzwerkkarte (130) umfassend ein Einsteckende (132), das zum Aufnehmen eines Verbinders (142) konfiguriert ist, wobei jede Netzwerkkarte (130) zum Ermöglichen einer Datenkommunikation zwischen dem Prozessor und einem anderen Prozessor konfiguriert ist, wobei das Rechen-Blade (10) **dadurch gekennzeichnet ist, dass** jede Netzwerkkarte (130) auf der Kühlplatte (120) montiert ist, wobei sie über ein Verbindungssystem (140) mit der Hauptplatine (110) verbunden ist, das System (140) umfassend einen ersten Verbinder (142), der mit dem Einsteckende (132) der Netzwerkkarte (130) verbunden ist, und einen zweiten Verbinder (144), der einerseits über ein Kabel (146) mit dem ersten Verbinder (142) und andererseits mit der Hauptplatine (110) verbunden ist.

2. Rechen-Blade (10) nach Anspruch 1, wobei der zweite Verbinder (144) über die Kühlplatte (120) an die Hauptplatine (110) angeschlossen ist.

3. Rechen-Blade (10) nach einem der vorstehenden Ansprüche, wobei jede Netzwerkkarte (130) über ein Trägerstück (150) an der Kühlplatte (120) montiert ist.

4. Rechen-Blade (10) nach dem vorstehenden Anspruch, wobei das Trägerstück (150) einen Körper (152) und eine Haltevorrichtung (154) des ersten Verbinders (142) umfasst, die an dem Körper (152) montiert ist.

5. Rechen-Blade (10) nach dem vorstehenden Anspruch, wobei die Haltevorrichtung (154) ein Träger-Blade (154L) des ersten Verbinders (142) und eine Halteplatte (154P) des ersten Verbinders (142) auf dem Träger-Blade (154L) umfasst.

6. Rechen-Blade (10) nach dem vorstehenden Anspruch, wobei das Träger-Blade (154L) aus Metall, vorzugsweise Aluminium, hergestellt ist.

7. Rechen-Blade (10) nach einem der Ansprüche 5 oder 6, wobei die Halteplatte (154P) aus Metall, vorzugsweise Stahl, hergestellt ist.

8. Rechen-Blade (10) nach einem der Ansprüche 5 bis 7, wobei die Halteplatte (154P) mithilfe von mindestens einer Schraube (156), vorzugsweise mithilfe von zwei Schrauben (156), an dem Träger-Blade (154L) befestigt ist.

9. Rechen-Blade (10) nach dem vorstehenden Anspruch, wobei die mindestens eine Schraube (156) verliergesichert oder unverlierbar ist und an der Halteplatte (154P) montiert ist.

10. Rechen-Blade (10) nach einem der Ansprüche 5 bis 9, wobei das Träger-Blade (154L) an dem Körper (152) des Trägerstücks (150) befestigt ist, wobei es um einen Abstand relativ zu der Kühlplatte (120) versetzt ist.

11. Rechen-Blade (10) nach einem der Ansprüche 3 bis 10, wobei der Körper (152) des Trägerstücks (150) aus einem Wärmeenergieleitermaterial hergestellt ist.

12. Rechen-Blade (10) nach dem vorstehenden Anspruch, wobei der Körper (152) des Trägerstücks (150) aus Aluminium hergestellt ist.

13. Rechen-Blade (10) nach einem der vorstehenden Ansprüche, wobei das Kabel (146) des Verbindungssystems (140) flexibel ist.

14. Rechen-Blade (10) nach einem der vorstehenden Ansprüche, wobei jede Netzwerkkarte (130) an einer Kante des Rechen-Blades (10) durch ein Befestigungsende befestigt ist, das dem Steckende (132) gegenüberliegt.

15. Supercomputer (1), umfassend mindestens ein Rechen-Blade (10) nach einem der vorstehenden Ansprüche.

## Claims

1. Computing blade (10) for a multi-blade supercomputer (1), the computing blade (10) comprising a motherboard (110), which comprises a plurality of processors mounted on a support, and a cold plate (120) sized to cover the support of the processors and comprising a plurality of heat sinks (122), a cooling circuit (124) comprising channels inside which a so-called "cold" heat transfer fluid flows, which is intended to supply the heat sinks (122), and an evacuation circuit (126) comprising channels through which a "hot" heat transfer fluid flows that has warmed up through the heat sinks (122), each heat sink (122) being mounted in line with a processor in order to cool it by heat exchange, the computing blade (10) comprising as many network cards (130) as processors, each network card (130) being associated with a processor, each network card (130) comprising a plug-in end (132) configured to receive a connector (142), each network card (130) being configured to enable data communication between the processor and another processor, the computing blade (10) being **characterised in that** each network card (130) is mounted on the cold plate (120) and is connected to the motherboard (110) via a connection system (140), the system (140) comprising a first connector (142) which is connected to the plug-in end (132) of the network card (130), and a second connector (144) which is connected on the one hand to the first connector (142) via a cable (146) and on the other hand to the motherboard (110).

2. Computing blade (10) according to claim 1, wherein the second connector (144) is connected to the motherboard (110) via the cold plate (120).

3. Computing blade (10) according to either of the preceding claims, wherein each network card (130) is mounted on the cold plate (120) via a support part (150).

4. Computing blade (10) according to the preceding claim, wherein the support part (150) comprises a body (152) and a holding device (154) for the first connector (142), mounted on the body (152).

5. Computing blade (10) according to the preceding claim, wherein the holding device (154) comprises a support blade (154L) for the first connector (142) and a holding plate (154P) for the first connector (142) on the support blade (154L).

6. Computing blade (10) according to the preceding claim, wherein the support blade (154L) is made of metal, preferably aluminium.

7. Computing blade (10) according to any of claims 5 or 6, wherein the holding plate (154P) is made of metal, preferably steel.

8. Computing blade (10) according to any of claims 5 to 7, wherein the holding plate (154P) is attached to the support blade (154L) by means of at least one screw (156), preferably by means of two screws (156).

9. Computing blade (10) according to the preceding claim, wherein the at least one screw (156) is captive, and mounted on the holding plate (154P).

10. Computing blade (10) according to any of claims 5 to 9, wherein the support blade (154L) is attached to the body (152) of the support part (150) at a distance from the cold plate (120).

11. Computing blade (10) according to any of claims 3 to 10, wherein the body (152) of the support part (150) is made of a thermally conductive material.

12. Computing blade (10) according to the preceding claim, wherein the body (152) of the support part (150) is made of aluminium.

13. Computing blade (10) according to any of the preceding claims, wherein the cable (146) of the connection system (140) is flexible.

14. Computing blade (10) according to any of the preceding claims, wherein each network card (130) is attached to an edge of the computing blade (10) by an attachment end, opposite the plug-in end (132).

15. Supercomputer (1) comprising at least one computing blade (10) according to any of the preceding claims.
